Europäisches Patentamt

(19) European Patent Office

Office européen des brevets

(11) Veröffentlichungsnummer : **0 033 003**
**B1**

(12) **EUROPÄISCHE PATENTSCHRIFT**

(45) Veröffentlichungstag der Patentschrift :
23.05.84

(51) Int. Cl.³ : **H 01 L 21/265**, H 01 L 29/78,
H 01 L 29/10

(21) Anmeldenummer : **80107940.1**

(22) Anmeldetag : **16.12.80**

(54) **Zweifach diffundierter Metalloxidsilicium-Feldeffekttransistor und Verfahren zu seiner Herstellung.**

(30) Priorität : **23.01.80 US 114484**

(43) Veröffentlichungstag der Anmeldung :
**05.08.81 Patentblatt 81/31**

(45) Bekanntmachung des Hinweises auf die Patenterteilung : **23.05.84 Patentblatt 84/21**

(84) Benannte Vertragsstaaten :
**DE FR GB**

(56) Entgegenhaltungen :
**US-A- 3 883 372**
**US-A- 3 909 320**
**US-A- 3 926 694**
**US-A- 3 959 025**
**US-A- 4 001 860**
**US-A- 4 108 686**
**ELECTRONICS, Band 44, Nr. 4, 15. Februar 1971,**
**NEW YORK (US) T.P. CAUGE u. a.: "Double-diffused**
**MOS transistor achieves microwave gain", Selten 99-**
**104**

(73) Patentinhaber : **International Business Machines Corporation**
**Old Orchard Road**
**Armonk, N.Y. 10504 (US)**

(72) Erfinder : **Bertin, Claude L.**
**33 Pheasant Way**
**South Burlington Vermont 05401 (US)**
Erfinder : **De La Moneda, Francisco H.**
**15 Nathan Hale Drive**
**Stormville New York 12582 (US)**
Erfinder : **Soderman, Donald A.**
**20131 Edinburgh Drive**
**Saratoga California 95070 (US)**

(74) Vertreter : **Rudack, Günter O., Dipl.-Ing.**
**c/o International Business Machines Corporation**
**Zurich Patent Operations Säumerstrasse 4**
**CH-8803 Rüschlikon (CH)**

**Beschreibung**

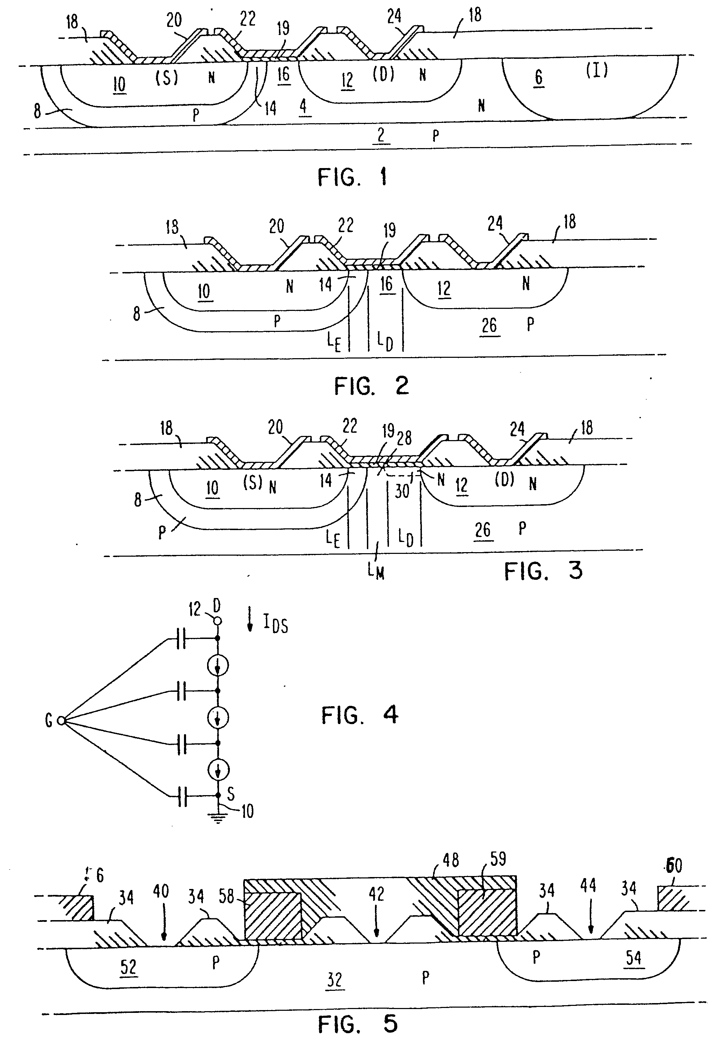

Die Erfindung betrifft einen zweifachen diffundierten Metalloxidsilicium-Feldeffekttransistor, wie er beispielsweise in dem Aufsatz von T. J. Rodgers, u. a., « An Experimental and Theoretical Analysis of Double Diffused MOS Transistors », in IEEE Journal of Solid State Circuits, Oktober 1975, Seiten 322 bis 331 beschrieben ist. Eine Querschnittsansicht eines derartigen DMOS-Transistors des Standes der Technik zeigt Fig. 1. Dieser Transistor besteht aus einem P-leitenden Siliciumsubstrat 2, auf dem eine N-leitende Epitaxialschicht 4 niedergeschlagen ist, und in welchen Diffusionszonen eingetrieben werden. Dabei sind 2 Diffusionszonen notwendig. Eine erste p-leitende Diffusionszone 8, definiert einen Kanal, dessen Länge etwa 1 µm beträgt und eine P-leitende Diffusionszone 6 (I) dient der Isolierung von benachbarten Transistoren. Eine zweite N-leitende Diffusionszone ist für die Sourcezone 10 (S) und Drainzone 12 (D) des DMOS-Transistors vorgesehen. Die effektive Kanalzone 14 liegt zwischen der Zone 16 der N-leitenden Epitaxialschicht 4 und der Sourcezone 10. Der Transistor wird dadurch vervollständigt, daß eine dünne Oxidschicht 19 über der Kanalzone 14 niedergeschlagen wird. Über dem Rest der Vorrichtung wird eine dicke Oxidschicht 18 niedergeschlagen, mit einer Öffnung über der Sourcezone 10 für eine Verbindung mit einem Sourcekontakt 20 sowie einer Öffnung über der Drainzone 12 für eine elektrisch leitende Verbindung zwischen einem Drainkontakt 24 und der Drainzone 12. Eine aus Metall oder Polysilicium bestehende Gateelektrode 22 wird dann zur Vervollständigung des Transistors über der dünnen Oxidschicht 19 niedergeschlagen.

Der wesentliche Vorteil dieses aus dem Stand der Technik bekannten DMOS-Transistors gemäß Fig. 1, liegt darin, daß die Länge des Kanals 14 von etwa 1 µm durch Warmbehandlungsverfahrensschritte und nicht durch photolithographische Verfahren festgelegt werden kann. Diese Struktur und dieses Herstellungverfahren sind jedoch aus verschiedenen Gründen nicht für hochintegrierte Schaltungen zu gebrauchen. Zunächst ist eine Epitaxialschicht 4 erforderlich, deren Dicke von etwa 2 bis 3 µm unterschiedliche Eigenschaften zur Folge hat, die wegen der Keimbildung die tatsächliche Ausbeute verringern. Außerdem benötigt die Isolationsdiffusionszone 6 einen beträchtlichen Teil der Oberfläche der Siliciumscheibe. Zudem ist auch eine zusätzliche Maske zum Herstellen der Öffnung für die Elektrode 24 oberhalb der Drainzone 12 erforderlich, nachdem die P-leitende Diffusionszone 14 gebildet ist.

Um diesen Nachteil zu beseitigen, sind abgewandelte DMOS-Strukturen im Stand der Technik bekannt geworden, wie sie beispielsweise in Fig. 2 dargestellt sind. Hier wird eine Struktur durch einen einfacheren Verfahrensablauf erzielt, bei einem einfacheren Verfahrensablauf erzielt, bei dem die N-leitende Epitaxialschicht 4 in Fig. 1 nicht mehr erforderlich ist. Man verwendet statt dessen ein einziges P-leitendes Substrat 26. Im übrigen ist die in Fig. 2 gezeigte Struktur die gleiche, wie die in Fig. 1 gezeigte, und die Bezugszeichen in beiden Figuren sind die gleichen.

In der oben genannten Veröffentlichung von Rodgers u. a. ist analytisch dargelegt, daß dann, wenn die in Fig. 2 dargestellte Vorrichtung die gleiche Drain-: Sourcestrom über Drain-: Sourcespannungskennlinie haben soll, wie die Struktur in Fig. 1, die folgende Ungleichung befriedigt werden muß :

$$\Delta V_T = (V_{TE} - V_{TD}) > 1/2\ E_C L_D.$$

$V_{TE}$ ist die Schwellwertspannung entsprechend der stark dotierten Anreicherungszone 14 des Kanals, die mit $L_E$ bezeichnet ist. $V_{TD}$ entspricht der leicht dotierten oder Verarmungszone des Kanals 16, die mit $L_D$ bezeichnet ist. $E_C$ ist das kritische elektrische Feld von $2 \times 10^4$ V/cm, bei der die Elektronengeschwindigkeitssättigung einzusetzen beginnt.

Um diese Ungleichung zu befriedigen, könnten die folgenden Schritte unternommen werden. Man könnte beispielsweise $L_D$ kurz machen, etwa in der Größenordnung von 1 µm für $\Delta V_T$ von 2 Volt. Dies ist jedoch keine praktische Lösung, da dabei kritische Toleranzen der Maskenabmessungen und ihrer Ausrichtung erforderlich sind, wobei dies genau die Schwierigkeiten sind, die DMOS eigentlich vermeiden sollte. Andererseits könnte man $V_{TD}$ so negativ wie möglich machen, indem man ein Substrat mit hohem spezifischen Widerstand verwendet, wie beispielsweise für ein Substrat mit 100 Ohm-Zentimeter von K. Ohta u. a. in einem Aufsatz mit dem Titel « A High Speed Logic LSI Using Diffusion Self-Aligned Enhancement Depletion MOS IC » in IEEE Journal of Solid State Circuits, Oktober 1975, auf Seiten 314-322 beschrieben haben. Diese Lösung bringt jedoch Schwierigkeiten durch Oberflächenleckströme und Durchschläge mit sich.

Die der Erfindung zugrundeliegende Aufgabe kann also dahingehend definiert werden, einen noch besseren diffundierten Metalloxidsilicium-Feldeffekttransistor zu schaffen, der noch einfacher herzustellen ist, eine gute Strom/Spannungskennlinie aufweist, für Unterschiede in den Maskenabmessungen oder der Maskenausrichtung nicht empfindlich ist und nicht zu übermäßigen Oberflächenleckströmen oder Durchschlägen neigt. Aus der US-A-4 001 860 ist es bekannt, ein parallel geschaltetes Paar von Feldeffekttransistoren zu bilden, die eine gemeinsame Drainzone aufweisen.

Diese der Erfindung zugrundeliegende Aufgabe wird durch das beanspruchte Herstellungsverfahren gelöst. Der bisher bekannte DMOS-Transistor wird dadurch verbessert, daß in die Drainzone eine Ausdehnung $L_D$ der Verarmungszone durch Ionenimplantation eingeführt wird. Die Einführung einer Ausdehnung $L_D$ der Verarmungszone führt jedoch zu gewissen statistischen Herstellungsschwankungen in den Kennlinien der so erzeugten Transistoren. Das Problem der Auswirkungen dieser Schwankungen in der Länge $L_D$ und damit die Schwankungen in der sich ergebenden Transistor-Steilheit wird dadurch gelöst, daß zwei dieser Transistoren parallel angeordnet werden. Wenn in einem Transistor die Länge $L_D$ relativ kürzer ist, dann ist in dem parallel dazu liegenden Transistor die Länge $L_D$ entsprechend länger. Das Verfahren zum Herstellen der zwei Transistoren erfolgt durch Ionenimplantation einer einzigen Leitfähigkeitszone, die die Zone $L_D$ sowohl für den linken als auch für den rechten Kanal des linken und rechten DMOS-Transistors bildet. Wenn die Maske für die implantierte Zone geringfügig nach rechts fehlausgerichtet ist, dann ist die effektive Länge $L_D$ für den rechts liegenden Kanal etwas größer, aber die wirksame Länge $L_D$ für den linken Kanal ist entsprechend kürzer, so daß die insgesamt aus der Parallelanordnung sich ergebende Transistor-Steilheit für die beiden Transistoren genau gleich bleibt, wie die Transistor-Steilheit für eine vollkommen symmetrisch hergestellte ionenimplantierte Zone.

Die Erfindung wird nunmehr anhand von Ausführungsbeispielen in Verbindung mit den beigefügten Zeichnungen im einzelnen näher erläutert. In den Zeichnungen zeigt

Figur 1 eine Querschnittsansicht eines ersten Beispiels des Standes der Technik,

Figur 2 eine Querschnittsansicht eines zweiten Beispiels des Standes der Technik,

Figur 3 eine Querschnittsansicht eines diffundierten MOS-Transistors zur Erläuterung von Teilen der Erfindung,

Figur 4 eine Prinzipschaltung der in Fig. 3 gezeigten Transistoren,

Figur 5 eine Querschnittsansicht zur Darstellung eines ersten erfindungsgemäßen Verfahrensschritts in der Herstellung des doppelten DMOS-Transistors,

Figur 6 eine Querschnittsansicht eines zweiten erfindungsgemäßen Verfahrensschritts bei der Herstellung des doppelten DMOS-transistors,

Figur 7 eine Querschnittsansicht eines dritten Verfahrensschritts bei der Herstellung des doppelten DMOS-transistors,

Figur 8 eine Querschnittsansicht eines nach dem erfindungsgemäßen Verfahren hergestellten fertigen doppelten DMOS-Transistors und

Figur 9 eine Draufsicht auf den doppelten DMOS-Transistor gemäß Fig. 8.

Beschreibung der bevorzugten Ausführungsformen der Erfindung

Ein diffundierter Metalloxidsilicium-Feldeffekttransistor (DMOS-Transistor) und ein Verfahren zu dessen Herstellung sind hier offenbart. Der bisher bekannte DMOS-Transistor des Standes der Technik wird dadurch verbessert, daß anschließend an die Drainzone eine zusätzliche Verarmungszone $L_D$ durch Ionenimplantation hergestellt wird. Diese Herstellung einer Ausdehnung $L_D$ der Verarmungszone führt jedoch zu statistischen Schwankungen in den Kennlinien der so hergestellten Transistoren. Die Schwierigkeiten der Auswirkungen dieser unterschiedlichen Längen von $L_D$ und damit die Schwankungen in der sich ergebenden Transistor-Steilheit der Transistoren wird dadurch gelöst, daß man zwei dieser Transistoren parallel anordnet. Wenn bei einem Transistor die Länge $L_D$ relativ kürzer ist, dann wird die Länge $L_D$ bei dem anderen parallel angeordneten Transistor entsprechend länger sein. Das Verfahren zum gleichzeitigen Herstellen von zwei solcher Transistoren erfolgt durch Ionenimplantation einer Zone mit nur einem Leitungstyp, der die Strecke $L_D$ sowohl für den linken, als auch für den rechten Kanal für beide DMOS-Transistoren liefert. Wenn die Maske für die ionenimplantierte Zone nur geringfügig nach rechts fehlausgerichtet ist, dann ist die effektive Länge $L_D$ für den rechten Kanal etwas länger, als die effektive Länge $L_D$ für den linken Kanal, die entsprechend kürzer ist, so daß insgesamt die Transistor-Steilheit für die beiden Transistoren genauso groß ist, wie die Transistor-Steilheit für eine vollkommen symmetrisch hergestellte ionenimplantierte Zone.

Will man bei einem in Fig. 2 dargestellten Transistor gemäß dem Stande der Technik die gleiche Kennlinie für den von Drain nach Source fließenden Strom über der zwischen Drain und Source liegenden Spannung erzielen, wie bei dem aus dem Stand der Technik gemäß Fig. 1 bekannten Transistor, dann muß man die Spannung $V_{TD}$ dadurch negativ machen, daß man anschließend an die eindiffundierte Drainzone in dem Abschnitt des Kanals außerhalb der P-leitenden Diffusionszone in Fig. 3 teilweise eine N-leitende Erweiterung 30 der Drainzone implantiert. Dabei muß ein ausreichend großer Zwischenraum 28, der mit $L_M$ bezeichnet ist, zwischen der Diffusionszone 8 und der Sollposition der Kante der implantierten Zone 30 verbleiben, so daß unter der größtmöglichen Fehlausrichtung der Anreicherungskanal 14, mit $L_E$ bezeichnet, nicht partiell implantiert wird. Man erhält damit außerhalb der diffundierten Kanalzone 14, wie in Fig. 3 gezeigt, zwei Dotierungsniveaus. Alle anderen Bezugszeichen sind in Fig. 3 die gleichen, wie in Fig. 2.

In Fig. 3 wird der implantierte Teil 30 des Kanals mit $L_D$ bezeichnet, und der Verbleibende Teil mit der ursprünglichen Dotierung des Substrats ist mit $L_M$ bezeichnet. Als ein nicht unerheblicher Nachteil der in Fig. 3 dargestellten Struktur ist die Abhängigkeit des Ausgangsstroms des Transistors von der Größe von $L_M$. Für spezifische Widerstände des Substrats in der Größenordnung von 2 Ohm-Zentimeter muß $L_M$ 1 μm oder kleiner sein, damit eine solche Abhängigkeit vermieden wird. Dies würde jedoch eine außergewöhnlich enge Toleranz für die Ausrichtung zwischen der Gatemaske und der Implantationsmaske erfordern, da jede Implantation der Zone 14 vermieden werden muß.

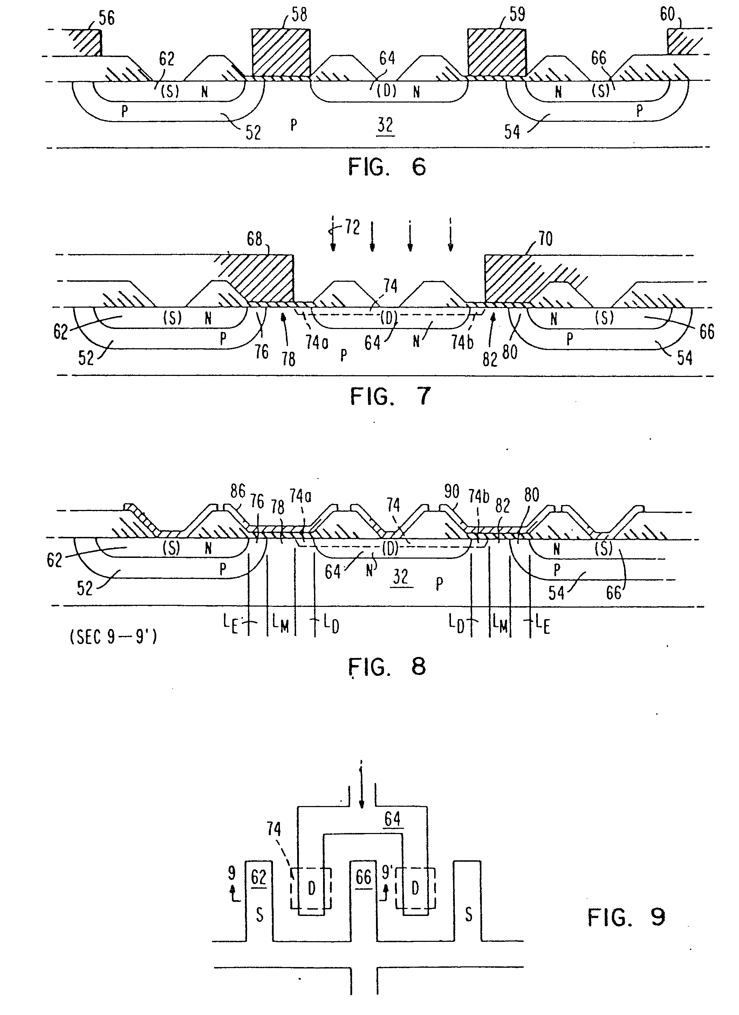

Eine Verbesserung der in Fig. 3 gezeigten Struktur, die die Auswirkungen einer Fehlausrichtung dieser Art beseitigt, ist in den Fign. 8 und 9 gezeigt, und die verschiedenen Verfahrensschritte zum Herstellen dieser Vorrichtung zeigen Fign. 5, 6 und 7.

Um die Vorteile, der in Fig. 8 dargestellten Vorrichtung zu verstehen, muß die Abhängigkeit der in Fig. 3 dargestellten Vorrichtung von einer unterschiedlichen Größe von $L_M$ untersucht werden. Die schematische, aus drei Vorrichtungen bestehende Schaltung in Fig. 4 zeigt diese Abhängigkeit. Die Kennlinie des von Drain nach Source fließenden Stroms über der zwischen Drain und Sourcezone liegenden Spannung für die in Fig. 4 gezeigte Schaltung kann anhand von bekannten Modellen und Parametern berechnet werden. Für die Längen $L_M$ und $L_D$ kann eine Normabweichung für ihre statistische Verteilung und die Auswirkung der entsprechenden Schwankungen auf den von Drain nach Source fließenden Strom untersucht werden. Verwendet man diese statistische Verteilung und andere Parameter mit ihrem Nennwert, dann kann eine Probe von 600 Fällen analysiert werden, und man erhält eine statistische Verteilung, die einen ziemlich konstanten Strom für $L_M$ bis zu einer bestimmten Größe liefert, worauf dann der Strom für eine größere Strecke $L_M$ monoton abnimmt. Es ist daher offenbar, daß für eine Struktur gemäß Fig. 3 der von Drain nach Source fließende Strom wegen der Fehlausrichtung von Masken noch eine merkliche Abweichung von einer Fertigungscharge zur anderen.

Fign. 5 bis 9 zeigen eine doppelt diffundierte MOS-Struktur, die die im Zusammenhang mit der Vorrichtung gemäß Fig. 3 auftretenden Probleme und Schwierigkeiten überwindet. Indem man zwei Ionenimplantierte DMOS-Transistoren parallel zueinander anordnet, kann die Abhängigkeit des Ausgangsstromes von der Ausrichtung der Ionenimplantation verringert werden. Fig. 8 zeigt dabei ein Paar DMOS-Transistoren mit einer gemeinsamen Draindiffusionszone 64 und einer einzigen Implantationszone 74, die über der gemeinsamen Drainzone liegt. Wie aus Fig. 8 zu ersehen, weist ein P-leitendes Substrat 32 eine P-leitende Diffusionszone 52 und eine N-leitende Diffusionszone 62 auf, die durch eine Öffnung in der Siliciumdioxidschicht 18 hindurch hergestellt wurden und damit eine diffundierte Kanalzone 76 bilden. Ein zweiter DMOS-Transistor wird in dem P-leitenden Substrat 32 mit der P-leitenden Diffusionszone 54 und der N-leitenden Diffusionszone 66 dadurch gebildet, daß durch eine zweite Source-Öffnung in der Siliciumdioxidschicht 18 eine zweite diffundierte Kanalzone 80 gebildet ist. Die diffundierte N-leitende Drainzone 64 wird durch eine in der Mitte zwischen der Sourcezone 62 und der Sourcezone 66 liegende Drainöffnung in der Siliciumdioxidschicht 18 eingebracht. Eine N-leitende Ionenimplantierte Zone 74 liegt über der diffundierten Drainzone 64, wobei das erste Ende 74 a sich in die Kanalzone 78 für den ersten Transistor erstreckt, während ein zweites Ende 74 b sich in die Kanalzone 82 für den zweiten Transistor erstreckt.

Wenn in Fig. 8 durch eine Fehlausrichtung ein DMOS-Transistor für den Kanalbereich 78, der mit $L_M$ bezeichnet ist, eine relativ große Länge aufweist, dann hat der parallel dazu angeordnete Transistor ein relativ geringere Länge $L_M$, die einen entsprechend höheren Strom zu Folge hat, die den aus dem ersten Transistor kommenden geringeren Strom ausgleicht. Daher werden Schwankungen des Ausgangsstromes für dieses Paar von Transistoren verringert. Eine Draufsicht auf den doppelten DMOS-Transistor gemäß Fig. 8 ist in Fig. 9 gezeigt.

Ein Herstellungsverfahren für den doppelten DMOS-Transistor von Fig. 8 zeigen Fign. 5, 6 und 7. In dem in Fig. 5 gezeigten Verfahrensschritt beginnt man mit einem P-leitenden Substrat 32, das mit einer Siliciumdioxidschicht 34 überzogen ist, die noch keine Öffnungen 40, 42 und 44 aufweist. Für die Ausrichtung der nachfolgend durch Ionenimplantation zu erzeugenden Zonen wird ein Verfahren mit einer gehärteten Photolackhauptmaske benutzt, wie es beispielsweise in der US-Patentschrift 4 102 126 beschrieben ist. In Fig. 5 wird eine aus gehärtetem Photolack bestehende Hauptmaske auf der Oberfläche der Siliciumdioxidschicht 34 niedergeschlagen, wobei dann die Bereiche 56, 58, 59 und 60 in bezug auf die Öffnungen 40, 42 und 44 übrigbleiben. Anschließend wird eine lösbare Photolackschicht 48 über den aus gehärtetem Photolack bestehenden Schichtabschnitten 58, 59 und der dazwischenliegenden Öffnung 42 niedergeschlagen. Zu diesem Zeitpunkt können die P-leitende-n Zone-n 52 und 54 durch die freiliegenden Teile der aus gehärtetem Photolack bestehenden Hauptmaske hindurch implantiert werden.

Gemäß Fig. 6 wird die lösbare Photolacksperrmaske 48 entfernt, und durch Ionenimplantation eines N-leitenden Störelements werden die N-leitende Sourcezone 62, die Drainzone 64 und die Sourcezone 6 hergestellt. In Fig. 7 wird die aus gehärtetem Photolack bestehende Hauptmaske entfernt, und es wird auf der Oberfläche eine übliche Photolackmaskenschicht niedergeschlagen, wobei die Abschnitte 68 und 70 stehenbleiben, so daß deren Kanten ungefähr in der Mitte der Kanalzonen 78 bzw. 82 liegen. Durch die Ionenimplantation von N-leitenden Störelementen 72, wird eine N-leitende Schicht 74 eingebaut, die über der N-leitenden Drainzone 64 liegt und sich in einem ersten Endabschnitt 74 a in die erste Kanalzone 78 und mit einem zweiten Endabschnitt 74 b in die zweite Kanalzone 82 hinein erstreckt. Die übrigen Verfahrensschritte zur Bildung von Source- und Drainelektroden und der Gateelektrode werden in üblicher Weise durchgeführt.

Durch die Erfindung können übliche Metall-

Gateelektroden auf Substraten mit geringem spezifischen Widerstand für DMOS-Transistoren dadurch brauchbar gemacht werden, daß man außerhalb der diffundierten Drainzone durch Ionenimplantation einen Verarmungskanal bildet. Durch die gleichzeitige parallele Anordnung eines Paares von DMOS-Transistoren, die durch eine Öffnung implantiert werden, die etwa um eine gemeinsame Draindiffusionszone zentriert ist, kann die Abhängigkeit des von Source nach Drain fließenden Stromes von der Länge der zusätzlichen Ausdehnung der Drainzone und der Maskenfehlausrichtung verringert werden. Diese Anordnung eignet sich insbesondere für ineinander verschachtelte Anordnungen von Transistoren für Ausgangstreiberstufen, die stärkere Ströme zu liefern in der Lage sind, wie sie der hier offenbarte doppelte DMOS-Transistor zu liefern vermag. Beispielsweise können die metallischen Gateelektroden 86 und 90 auch aus polykristallinem Siliciummaterial bestehen.

**Ansprüche**

1. Verfahren zum Herstellen diffundierter Metalloxid-Silicium-Feldeffekttransistoren mit vorausbestimmbarer Transistor-Steilheit, gekennzeichnet durch folgende Verfahrensschritte :

Bilden einer ersten (52) und in einem ersten Abstand davon einer zweiten Zone (54) eines ersten Leitungstyps, in einem Substrat (32) des ersten Leitungstyps,

Bilden einer ersten und einer zweiten Zone (62, 66) eines zweiten Leitungstyps innerhalb der ersten und der zweiten Zone des ersten Leitungstyps und Bilden einer dritten Zone (64) des zweiten Leitungstyps zwischen der ersten und der zweiten Zone (52, 54) des ersten Leitungstyps mit einem zweiten Abstand von der ersten Zone des ersten Leitungstyps und einem dritten Abstand von der zweiten Zone des ersten Leitungstyps für eine gemeinsame Drainzone zweier Feldeffekt-Transistoren, wobei die erste und die zweite Zone des zweiten Leitungstyps jeweils als Source-Zone der beiden FET dienen,

Implantieren von Ionen des zweiten Leitungstyps in eine über der dritten Zone (64) des zweiten Leitungstyps liegende Schicht (74) des Substrats (32), welche sich nach beiden Seiten in den Bereich hinein erstreckt, der die dritte Zone (64) des zweiten Leitungstyps jeweils von den benachbarten ersten bzw. zweiten Zonen (52, 54) des ersten Leitungstyps trennt, wodurch ein parallel geschaltetes Paar von Feldeffekt-Transistoren gebildet wird, bei denen die Transistor-Steilheit des ersten FET eine durch eine Fehlausrichtung der vorgegebenen Öffnung der Implantationsmaske verursachte Abweichung der Transistor-Steilheit des zweiten Transistors kompensiert.

2. Verfahren nach Anspruch 1, dadurch gekennzeichnet, daß zur Bildung der ersten und zweiten Zonen (52, 54) des ersten Leitungstyps und der ersten und zweiten Zonen des zweiten Leitungstyps Störelemente eindiffundiert werden.

3. Verfahren nach Anspruch 1, dadurch gekennzeichnet, daß die ersten und zweiten Zonen des ersten und des zweiten Leitungstyps durch Ionenimplantation von Störelementen gebildet werden.

**Claims**

1. Method for forming diffused metal-oxide silicon field-effect transistors with predictable transconductance, characterized by the following steps :

forming first (52) and second (54) regions of a first conductivity type, separated by a first distance on a substrate (32) of the first conductivity type ;

forming first and second regions (62, 66) of a second conductivity type within said first and second regions of said first conductivity type, and forming a third region (64) of the second conductivity type between said first and second regions (52, 54) of said first conductivity type with a second distance from the first region of the first conductivity type, and a third distance from the second region of the first conductivity type, for a common drain region of two field-effect transistors, the first and second regions of the second conductivity type serving as the respective source regions of the two FET ;

implanting of ions of the second conductivity type into a layer (74) of the substrate (32) lying over the third region (64) of the second conductivity type, the layer (74) extending on both sides into the region separating the third region (64) of the second conductivity type from the neighbouring first and second regions (52, 54) of the first conductivity type, whereby a parallel-connected pair of field-effect transistors is formed in which the transconductance of the first FET compensates the deviation of the transconductance of the second transistor caused by the misalignment of the predetermined opening of the implantation mask.

2. Method according to claim 1, characterized in that for forming the first and second regions (52, 54) of the first conductivity type and the first and second regions of the second conductivity type dopants are diffused.

3. Method according to claim 1, characterized in that the first and second regions of the first and second conductivity type are formed by ion implantation of dopants.

**Revendications**

1. Procédé pour fabriquer des transistors à effet de champ métal-oxyde-silicium diffusés, possédant une pente pouvant être prédéterminée, caractérisé par les phases opératoires suivantes :

formation d'une première zone (52) et, à une première distance de cette zone, d'une seconde zone (54) possédant un premier type de conductivité, dans un substrat (32) possédant le premier type de conductivité,

formation d'une première et d'une seconde zones (62, 66) possédant un second type de conductivité à l'intérieur de la première et de la seconde zones possédant le premier type de conductivité et formation d'une troisième zone (64) possédant le second type de conductivité entre la première et la seconde zones (52, 54) possédant le premier type de conductivité, à une seconde distance de la première zone possédant le premier type de conductivité et à une troisième distance de la seconde zone possédant le premier type de conductivité pour une zone de drain commune des deux transistors à effet de champ, la première et la seconde zones possédant le second type de conductivité servant respectivement de zones de source des deux transistors à effet de champ,

implantation d'ions possédant le second type de conductivité dans une couche (74) du substrat (32), située au-dessus de la troisième zone (64) possédant le second type de conductivité et qui s'étend des deux côtés dans la région qui sépare la troisième zone (64) possédant le second type de conductivité, respectivement des première et seconde zones voisines (52, 54- possédant le premier type de conductivité, en formant de ce fait un couple de transistors à effet de champ branchés en parallèle, pour lesquels la pente du premier transistor à effet de champ compense une variation de la pente du second transistor, qui est provoquée par un alignement défectueux de l'ouverture prédéterminée du masque d'implantation.

2. Procédé selon la revendication 1, caractérisé en ce qu'on fait pénétrer par diffusion des éléments d'impureté pour former la première et la seconde zones (52, 54) possédant le premier type de conductivité et la première et la seconde zones possédant le second type de conductivité.

3. Procédé selon la revendication 1, caractérisé en ce que les première et seconde zones possédant le premier et le second type de conductivité sont formés par implantation d'ions d'impuretés.

FIG. 1

FIG. 2

FIG. 3

FIG. 4

FIG. 5

FIG. 6

FIG. 7

(SEC 9—9')

FIG. 8

FIG. 9

2